# DEMANDE DE BREVET EUROPEEN

(11) **EP 4 791 137 A1**
(43) Date de publication de la demande: **12.08.2026**
(21) Numéro de dépôt: 26157671.4
(22) Date de dépôt: 10.02.2026
(51) Int. Cl.: H05K 7/20, H10W 40/60, H10W 90/10, H10W 40/47, H10W 40/20

(54) **ENSEMBLE ÉLECTRONIQUE, NOTAMMENT CONFIGURÉ POUR ÊTRE INTÉGRÉ DANS UN ONDULEUR**

(30) Priorité: 11.02.2025 FR 2501428
(71) Demandeur: Valeo Electrification, 95892 Cergy Pontoise (FR)
(72) Inventeur: HENNEGUET, Romain, 62630 Etaples-sur-Mer (FR); THANGARAJAN, Vivek, 600130 Chennai, Tamil Nadu (IN); MARSHAL, Belber, 600130 Chennai, Tamil Nadu (IN)
(74) Mandataire: Valeo Powertrain Systems

(57) **Abrégé**

L'invention concerne un ensemble électronique (1) comportant :
- un premier dispositif de refroidissement (2) comportant une première face de contact thermique (4),
- un deuxième dispositif de refroidissement (3) comportant une deuxième face de contact thermique (5) et une face d'appui,
- au moins un module électronique de puissance (7),
- une structure de maintien (6) comportant au moins une portion élastique (8),
- une pluralité d'éléments de fixation (30),
caractérisé en ce que la pluralité d'éléments de fixation (30) exerce une force sur la structure de maintien (6) générant sur la face d'appui du deuxième dispositif de refroidissement (3) des efforts de serrage suffisants pour solidariser ensemble le premier dispositif de refroidissement (2), le deuxième dispositif de refroidissement (3) et la structure de maintien (6).

## Description

### Domaine de l'invention

La présente invention concerne notamment un ensemble électronique, notamment configuré pour être intégré dans un onduleur.

### État de la technique

On connaît par la demande de brevet WO2022248427 une structure de refroidissement comprenant des structures empilées formant un réseau d'ouvertures et de chambres pour l'écoulement d'un fluide de refroidissement. Cette structure est placée dans un conduit et ce conduit est fermé par une structure de base d'un module électronique de puissance. Le fluide de refroidissement parcourt des méandres au sein de cette structure.

L'invention vise à proposer un nouveau type de dispositif de régulation thermique.

### Exposé de l'invention

L'invention concerne un ensemble électronique comportant :
- un premier dispositif de refroidissement comportant une première face de contact thermique,
- un deuxième dispositif de refroidissement comportant une deuxième face de contact thermique et une face d'appui,
- au moins un module électronique de puissance présentant une première face et une deuxième face, notamment parallèles entre elles, la première face du module électronique de puissance étant en contact thermique avec la première face de contact thermique du premier dispositif de refroidissement et la deuxième face du module électronique de puissance étant en contact thermique avec la deuxième face de contact thermique du deuxième dispositif de refroidissement,
- une structure de maintien placée au contact de la face d'appui du deuxième dispositif de refroidissement, et comportant au moins une portion élastique,
- une pluralité d'éléments de fixation,
caractérisé en ce que :
▪ le premier dispositif de refroidissement et la portion élastique de la structure de maintien comportent chacun une pluralité d'orifices de fixation,
▪ la pluralité d'éléments de fixation traverse les orifices de fixation et exerce une force sur la structure de maintien, générant une déformation des portions élastiques de la structure de maintien, cette déformation générant sur la face d'appui du deuxième dispositif de refroidissement des efforts de serrage suffisants pour solidariser ensemble le premier dispositif de refroidissement, le deuxième dispositif de refroidissement et la structure de maintien.

Avantageusement, l'invention permet de diminuer la distance entre les dispositifs de refroidissement et le module électronique de puissance.

Avantageusement, l'utilisation d'une structure de maintien comportant une portion élastique permet d'assembler l'ensemble électronique comme un assemblage autonome, sans nécessiter la fixation sur une pièce support.

Il est ainsi possible d'assembler intégralement l'ensemble électronique avant sa fixation à d'autres composants.

Selon l'un des aspects de l'invention, la structure de maintien comporte une face de maintien arrangée pour être placée au contact de la face d'appui du deuxième dispositif de refroidissement.

Selon l'un des aspects de l'invention, la structure de maintien comporte une pluralité de portions élastique.

Selon un aspect de l'invention, la structure de maintien comporte une pluralité d'ailettes formant des portions élastiques de la structure de maintien, et s'étendant depuis la face de maintien de la structure de maintien.

Selon un aspect de l'invention, les ailettes s'étendent de part et d'autre du deuxième dispositif de refroidissement, et ne sont pas en contact avec le deuxième dispositif de refroidissement.

Selon un aspect de l'invention, la structure de maintien comporte une pluralité de pates de maintien.

Selon un aspect de l'invention, les pates de maintien comportent une portion plane faisant partie de la face de maintien de la structure de maintien, et une portion coudée arrangée pour venir au contact d'une face latérale du deuxième dispositif de refroidissement de manière à maintenir le deuxième dispositif de refroidissement en position latéralement.

On nomme face latérale du deuxième dispositif de refroidissement les faces du deuxième dispositif de refroidissement sensiblement perpendiculaires à la face d'appui du deuxième dispositif de refroidissement.

Selon un aspect de l'invention, la structure de maintien comporte au moins deux pattes de maintien placées en contact avec des faces latérales opposées du deuxième dispositif de refroidissement.

Selon un aspect de l'invention, la structure de maintien est réalisée en matériau métallique, notamment en aluminium.

Selon l'un des aspects de l'invention, le premier dispositif de refroidissement comporte un premier canal de circulation pour un fluide caloporteur.

Selon l'un des aspects de l'invention, le deuxième dispositif de refroidissement comporte un deuxième canal de circulation pour un fluide caloporteur.

Selon l'un des aspects de l'invention, le premier canal et/ou le deuxième canal de circulation de fluide caloporteur sont de section sensiblement rectangulaire.

Selon un aspect de l'invention, le ou les modules électroniques de puissance sont pris intercalés entre le premier dispositif de refroidissement et le deuxième dispositif de refroidissement.

Avantageusement, l'invention permet ainsi de refroidir le module électronique de puissance sur ses deux faces, permettant ainsi d'évacuer une plus grande quantité de chaleur.

Avantageusement, le premier dispositif de refroidissement et le deuxième dispositif de refroidissement étant à circulation de fluide caloporteur, ils permettent d'évacuer plus efficacement la chaleur dégagée par le module électronique de puissance lors de son fonctionnement.

Selon l'un des aspects de l'invention, le premier dispositif de refroidissement et le deuxième dispositif de refroidissement comportent chacun des plaques configurées pour former au moins un canal de circulation pour un fluide caloporteur, l'une des plaques définissant respectivement la première face de contact thermique et la deuxième face de contact thermique.

Dans ce cas, le premier dispositif de refroidissement et le deuxième dispositif de refroidissement sont de construction similaire, à savoir avec un canal de fluide caloporteur formé par des plaques.

Selon l'un des aspects de l'invention, le canal de circulation de fluide caloporteur du premier dispositif de refroidissement et/ou du deuxième dispositif de refroidissement présente une forme globalement rectiligne.

Selon l'un des aspects de l'invention, le premier dispositif de refroidissement et le deuxième dispositif de refroidissement sont réalisés en métal, par exemple en aluminium.

Selon l'un des aspects de l'invention, une matière d'interface thermique (par exemple en anglais « gap filler » ou pâte thermique ou graisse thermique ou un film) est présente entre la première face du module électronique de puissance et la première face de contact thermique du premier dispositif de refroidissement.

Selon l'un des aspects de l'invention, une telle matière d'interface thermique est présente également présente entre la deuxième face du module électronique et la deuxième face de contact thermique du deuxième dispositif de refroidissement.

Selon l'un des aspects de l'invention, l'ensemble électronique comporte une pluralité de module électronique de puissance, par exemple deux ou trois modules électroniques de puissance, notamment disposés suivant une rangée, et intercalés entre le premier dispositif de refroidissement et le deuxième dispositif de refroidissement.

Selon l'un des aspects de l'invention, l'ensemble électronique comporte un support de positionnement arrangé recevoir le ou les module électronique de puissance et pour permettre le positionnement relatif du module électronique de puissance, du premier dispositif de refroidissement et du deuxième dispositif de refroidissement lors de l'assemblage de l'ensemble électronique.

Selon l'un des aspects de l'invention, le support de positionnement a une forme de cadre, et comporte une pluralité d'ouvertures de positionnement, notamment autant d'ouvertures de positionnement que de modules électronique de puissance, chaque ouverture de positionnement étant arrangée pour accueillir un module électronique de puissance.

Notamment, le support de positionnement comporte trois ouvertures de positionnement.

Selon l'un des aspects de l'invention, le support de positionnement comporte une face supérieure et une face inférieure.

Selon l'un des aspects de l'invention, la face supérieure du support de positionnement est placée au contact du premier dispositif de refroidissement, et comporte des reliefs de positionnement permettant de positionner le premier dispositif de refroidissement sur le support de positionnement.

Selon l'un des aspects de l'invention, la face inférieure du support de positionnement est placée au contact du deuxième dispositif de refroidissement, et comporte des reliefs de positionnement permettant de positionner le deuxième dispositif de refroidissement sur le support de positionnement.

Selon l'un des aspects de l'invention, le support de positionnement est intercalé entre le premier dispositif de refroidissement et le deuxième dispositif de refroidissement, et forme un empilement avec le premier dispositif de refroidissement et le deuxième dispositif de refroidissement.

Selon l'un des aspects de l'invention, le support de positionnement est réalisé en métal ou en matière plastique.

Selon un aspect de l'invention, les éléments de fixation sont des vis.

Selon un aspect de l'invention, les éléments de fixation :
- exercent une force sur la structure de maintien,
- exercent une force opposée sur le premier dispositif de refroidissement.

Selon un aspect de l'invention, les éléments de fixation sont fixés directement au premier dispositif de refroidissement, et appliquent une force directement sur le premier dispositif de refroidissement.

Par exemple, les éléments de fixation sont des vis vissées directement dans un orifice de fixation du premier dispositif de refroidissement.

Selon un autre mode de réalisation de l'invention, les éléments de fixation sont fixés à des pièces intermédiaires placées en appui sur le deuxième dispositif de refroidissement, et exerçant la force opposée sur le premier dispositif de refroidissement.

Par exemple, les éléments de fixation sont des vis vissées sur des écrous placés en appui sur le premier dispositif de refroidissement.

Selon l'un des aspects de l'invention, l'ensemble électronique comporte une pluralité de bagues d'ajustement.

Selon l'un des aspects de l'invention, les bagues d'ajustement sont de forme tubulaires, et sont placées autour des éléments de fixation de l'ensemble électronique.

Selon l'un des aspects de l'invention, les bagues d'ajustement comportent une face supérieure et une face inférieure.

Selon l'un des aspects de l'invention, la face inférieure des bagues d'ajustement est placée au contact d'une surface plane du support de positionnement et/ou du premier dispositif de refroidissement.

Selon l'un des aspects de l'invention, la face supérieure des bagues d'ajustement est parallèle à la structure de maintien, et est placée en regard d'une zone élastique de la structure de maintien de sorte que :
- lorsque la structure de maintien est placée sans déformation au contact du deuxième dispositif de refroidissement, la face supérieure des bagues d'ajustement est placée à une distance D de la structure de maintien,
- lorsque la structure de maintien est déformée par la force exercée par les éléments de fixation, les parties élastiques de la structure de maintien sont au contact de la face supérieure des bagues d'ajustement.

Avantageusement, la hauteur des bagues d'ajustement permet d'ajuster la distance D entre la structure de maintien et la face supérieure des bagues d'ajustement, et ainsi d'ajuster la déformation maximale des parties élastiques de la structure de maintien.

Selon un aspect de l'invention, l'ajustement de la hauteur des bagues d'ajustement permet d'ajuster les efforts verticaux générés sur la face d'appui du deuxième dispositif de refroidissement par la structure de maintien.

L'ensemble électronique est notamment configuré pour être intégré dans un onduleur. L'invention a encore pour objet un onduleur comportant un ensemble électronique tel que précité.

### Liste des figures

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig 1] La figure 1 est une vue en perspective d'un ensemble électronique selon l'invention.
[Fig. 2] La figure 2 est une vue en coupe d'un ensemble électronique selon l'invention, avant le serrage des éléments de fixation.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

### Description détaillée

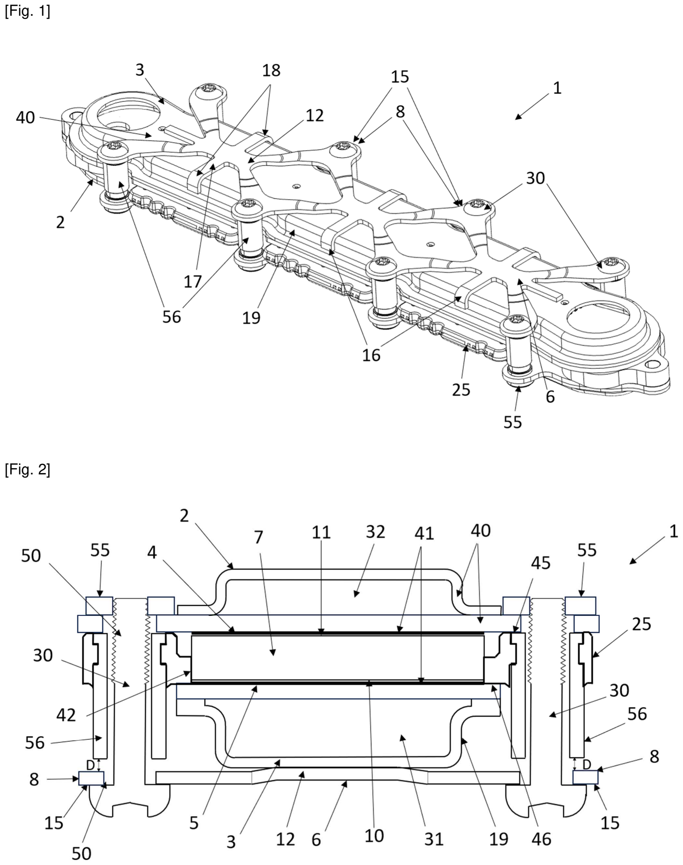

On a représenté sur la figure 1, un ensemble électronique 1 selon l'invention.

L'ensemble électronique 1 comporte :
- un premier dispositif de refroidissement 2 comportant une première face de contact thermique 4,
- un deuxième dispositif de refroidissement 3 comportant une deuxième face de contact thermique 5 et une face d'appui,
- trois modules électroniques de puissance 7 présentant une première face 10 et une deuxième face 11, notamment parallèles entre elles, la première face 10 des modules électroniques de puissance 7 étant en contact thermique avec la première face de contact thermique 4 du premier dispositif de refroidissement 2 et la deuxième face 11 des modules électronique de puissance étant en contact thermique avec la deuxième face de contact thermique 5 du deuxième dispositif de refroidissement 3,
- une structure de maintien 6 placée au contact de la face d'appui du deuxième dispositif de refroidissement 3, et comportant au moins une portion élastique 8,
- une pluralité d'éléments de fixation 30.

La structure de maintien 6 comporte une face de maintien 12 arrangée pour être placée au contact de la face d'appui du deuxième dispositif de refroidissement 3.

La structure de maintien 6 comporte une pluralité de portions élastiques 8.

La structure de maintien 6 comporte une pluralité d'ailettes 15 formant des portions élastiques 8 de la structure de maintien 6, et s'étendant depuis la face de maintien de la structure de maintien 6.

Les ailettes 15 s'étendent de part et d'autre du deuxième dispositif de refroidissement 3, et ne sont pas en contact avec le deuxième dispositif de refroidissement 3.

La structure de maintien 6 comporte une pluralité de pates de maintien 16 comportant chacune une portion plane 17 faisant partie de la face de maintien 12 de la structure de maintien 6, et une portion coudée 18 arrangée pour venir au contact d'une face latérale 19 du deuxième dispositif de refroidissement 3 de manière à maintenir le deuxième dispositif de refroidissement 3 en position latéralement.

On nomme face latérale 19 du deuxième dispositif de refroidissement 3 les faces du deuxième dispositif de refroidissement 3 sensiblement perpendiculaires à la face d'appui du deuxième dispositif de refroidissement 3.

La structure de maintien 6 comporte au moins deux pattes de maintien 16 placées en contact avec des faces latérales 19 opposées du deuxième dispositif de refroidissement 3.

La structure de maintien 6 est réalisée en matériau métallique, notamment en aluminium.

L'ensemble électronique 1 comporte trois modules électroniques de puissance 7, notamment disposés suivant une rangée, et intercalés entre le premier dispositif de refroidissement 2 et le deuxième dispositif de refroidissement 3.

L'ensemble électronique 1 comporte un support de positionnement 25 arrangé recevoir les modules électroniques de puissance 7 et pour permettre le positionnement relatif des modules électroniques de puissance 7, du premier dispositif de refroidissement 2 et du deuxième dispositif de refroidissement 3 lors de l'assemblage de l'ensemble électronique 1.

On a représenté sur la figure 2 une vue en coupe d'un ensemble électronique 1 selon l'invention, avant le serrage des éléments de fixation 30.

Le premier dispositif de refroidissement 2 comporte un premier canal 31 de circulation pour un fluide caloporteur, et le deuxième dispositif de refroidissement 3 comporte un deuxième canal 32 de circulation pour un fluide caloporteur.

Le premier canal 31 et le deuxième canal de circulation 32 de fluide caloporteur sont de section sensiblement rectangulaire.

Les modules électroniques de puissance 7 sont pris intercalés entre le premier dispositif de refroidissement 2 et le deuxième dispositif de refroidissement 3.

Avantageusement, l'invention permet ainsi de refroidir le module électronique de puissance 7 sur ses deux faces, permettant ainsi d'évacuer une plus grande quantité de chaleur.

Avantageusement, le premier dispositif de refroidissement 2 et le deuxième dispositif de refroidissement 3 étant à circulation de fluide caloporteur, ils permettent d'évacuer plus efficacement la chaleur dégagée par le module électronique de puissance 7 lors de son fonctionnement.

Le premier dispositif de refroidissement 2 et le deuxième dispositif de refroidissement 3 comportent chacun des plaques 40 configurées pour former au moins un canal de circulation pour un fluide caloporteur, l'une des plaque 40 définissant respectivement la première face de contact thermique 4 et la deuxième face de contact thermique 5.

Le premier dispositif de refroidissement 2 et le deuxième dispositif de refroidissement 3 sont de construction similaire, à savoir avec un canal de fluide caloporteur formé par des plaques 40.

Le canal de circulation de fluide caloporteur du premier dispositif de refroidissement 2 et du deuxième dispositif de refroidissement 3 présentent une forme globalement rectiligne.

Le premier dispositif de refroidissement 2 et le deuxième dispositif de refroidissement 3 sont réalisés en métal, par exemple en aluminium.

Selon l'un des aspects de l'invention, une matière d'interface thermique 41 (par exemple en anglais « gap filler » ou pâte thermique ou graisse thermique ou un film) est présente entre la première face 10 du module électronique de puissance 7 et la première face de contact thermique 4 du premier dispositif de refroidissement 2, et entre la deuxième face 11 du module électronique de puissance 7 et la deuxième face de contact thermique 5 du deuxième dispositif de refroidissement 3.

Le support de positionnement 25 a une forme de cadre, et comporte une pluralité d'ouvertures de positionnement 42, notamment autant d'ouvertures de positionnement que de modules électronique de puissance, chaque ouverture de positionnement étant arrangée pour accueillir un module électronique de puissance 7.

Ici, le support de positionnement 25 comporte trois ouvertures de positionnement.

Le support de positionnement 25 comporte une face supérieure 45 et une face inférieure 46.

La face supérieure 45 du support de positionnement 25 est placée au contact du premier dispositif de refroidissement 2, et comporte des reliefs de positionnement permettant de positionner le premier dispositif de refroidissement 2 sur le support de positionnement 25.

La face inférieure 46 du support de positionnement 25 est placée au contact du deuxième dispositif de refroidissement 3, et comporte des reliefs de positionnement permettant de positionner le deuxième dispositif de refroidissement 3 sur le support de positionnement 25.

Le support de positionnement 25 est intercalé entre le premier dispositif de refroidissement 2 et le deuxième dispositif de refroidissement 3, et forme un empilement avec le premier dispositif de refroidissement 2 et le deuxième dispositif de refroidissement 3.

Le support de positionnement 25 est réalisé en métal ou en matière plastique.

Les éléments de fixation 30 sont des vis.

Les éléments de fixation 30 exercent une force sur la structure de maintien 6, et exercent une force opposée sur le premier dispositif de refroidissement 2.

Le premier dispositif de refroidissement 2 et la portion élastique 8 de la structure de maintien 6 comportent chacun une pluralité d'orifices de fixation 50.

Selon un mode de réalisation de l'invention non représenté, les éléments de fixation 30 sont fixés directement au premier dispositif de refroidissement 2, et appliquent une force directement sur le premier dispositif de refroidissement 2.

Par exemple, les éléments de fixation 30 sont des vis vissées directement dans un orifice de fixation 50 du premier dispositif de refroidissement 2.

Selon un autre mode de réalisation de l'invention, les éléments de fixation 30 sont fixés à des pièces intermédiaires 55 placées en appui sur le deuxième dispositif de refroidissement 3, et exerçant la force opposée sur le premier dispositif de refroidissement 2.

Par exemple, les éléments de fixation sont des vis 30 vissées sur des écrous 55 placés en appui sur le premier dispositif de refroidissement 2.

L'ensemble électronique 1 comporte une pluralité de bagues d'ajustement 56.

Les bagues d'ajustement 56 sont de forme tubulaires, et sont placées autour des éléments de fixation 30 de l'ensemble électronique 1.

Les bagues d'ajustement 56 comportent une face supérieure et une face inférieure.

La face inférieure des bagues d'ajustement 56 est placée au contact d'une surface plane du support de positionnement 25 et du premier dispositif de refroidissement, et la face supérieure des bagues d'ajustement 56 est parallèle à la structure de maintien 6, et est placée en regard d'une zone élastique de la structure de maintien 6 de sorte que :
- lorsque la structure de maintien 6 est placée sans déformation au contact du deuxième dispositif de refroidissement 3, la face supérieure des bagues d'ajustement 56 est placée à une distance D de la structure de maintien 6,
- lorsque la structure de maintien 6 est déformée par la force exercée par les vis, les parties élastiques de la structure de maintien 6 sont au contact de la face supérieure des bagues d'ajustement 56.

Avantageusement, la hauteur des bagues d'ajustement 56 permet d'ajuster la distance D entre la structure de maintien 6 et la face supérieure des bagues d'ajustement 56, et ainsi d'ajuster la déformation maximale des parties élastiques de la structure de maintien 6.

Avantageusement, l'ajustement de la hauteur des bagues d'ajustement 56 permet d'ajuster les efforts verticaux générés sur la face d'appui du deuxième dispositif de refroidissement 3 par la structure de maintien 6.

La pluralité d'éléments de fixation 30 traverse les orifices de fixation 50 et exerce une force sur la structure de maintien 6, générant une déformation des portions élastiques 8 de la structure de maintien 6, cette déformation générant sur la face d'appui du deuxième dispositif de refroidissement 3 des efforts de serrage suffisants pour solidariser ensemble le premier dispositif de refroidissement 2, le deuxième dispositif de refroidissement 3 et la structure de maintien 6.

Avantageusement, l'invention permet de diminuer la distance entre les dispositifs de refroidissement et le module électronique de puissance 7.

Avantageusement, l'utilisation d'une structure de maintien 6 comportant une portion élastique 8 permet d'assembler l'ensemble électronique 1 comme un assemblage autonome, sans nécessiter la fixation sur une pièce support.

**Il** est ainsi possible d'assembler intégralement l'ensemble électronique 1 avant sa fixation à d'autres composants.

L'ensemble électronique 1 est notamment configuré pour être intégré dans un onduleur.

## Revendications

1. Ensemble électronique (1) comportant :
- un premier dispositif de refroidissement (2) comportant une première face de contact thermique (4),
- un deuxième dispositif de refroidissement (3) comportant une deuxième face de contact thermique (5) et une face d'appui,
- au moins un module électronique de puissance (7) présentant une première face (10) et une deuxième face (11), notamment parallèles entre elles, la première face (10) du module électronique de puissance (7) étant en contact thermique avec la première face de contact thermique (4) du premier dispositif de refroidissement (2) et la deuxième face (11) du module électronique de puissance (7) étant en contact thermique avec la deuxième face de contact thermique (5) du deuxième dispositif de refroidissement (3),
- une structure de maintien (6) placée au contact de la face d'appui du deuxième dispositif de refroidissement (3), et comportant au moins une portion élastique (8),
- une pluralité d'éléments de fixation (30),
**caractérisé en ce que** :
• le premier dispositif de refroidissement (2) et la portion élastique (8) de la structure de maintien (6) comportent chacun une pluralité d'orifices de fixation (50),
• la pluralité d'éléments de fixation (30) traverse les orifices de fixation (50) et exerce une force sur la structure de maintien (6), générant une déformation des portions élastiques (8) de la structure de maintien (6), cette déformation générant sur la face d'appui du deuxième dispositif de refroidissement (3) des efforts de serrage suffisants pour solidariser ensemble le premier dispositif de refroidissement (2), le deuxième dispositif de refroidissement (3) et la structure de maintien (6).

2. Ensemble électronique (1) selon la revendication 1, dans lequel la structure de maintien (6) comporte une pluralité d'ailettes (15) formant des portions élastiques (8) de la structure de maintien (6), et s'étendant depuis la face de maintien (12) de la structure de maintien (6) de part et d'autre du deuxième dispositif de refroidissement (3), et n'étant pas en contact avec le deuxième dispositif de refroidissement (3).

3. Ensemble électronique (1) selon l'une des revendications précédentes, dans lequel la structure de maintien (6) comporte une pluralité de pates de maintien comportant une portion plane (17) faisant partie de la face de maintien (12) de la structure de maintien (6), et une portion coudée (18) arrangée pour venir au contact d'une face latérale (19) du deuxième dispositif de refroidissement (3) de manière à maintenir le deuxième dispositif de refroidissement (3) en position latéralement.

4. Ensemble électronique (1) selon l'une des revendications précédentes, dans lequel la structure de maintien (6) est réalisée en matériau métallique, notamment en aluminium.

5. Ensemble électronique (1) selon l'une des revendications précédentes, dans lequel le premier dispositif de refroidissement (2) comporte un premier canal (31) de circulation pour un fluide caloporteur et/ou dans lequel le deuxième dispositif de refroidissement (3) comporte un deuxième canal (32) de circulation pour un fluide caloporteur.

6. Ensemble électronique (1) selon l'une des revendications précédentes, dans lequel une matière d'interface thermique (41) est présente entre la première face (10) du module électronique de puissance (7) et la première face de contact thermique (4) du premier dispositif de refroidissement (2) et/ou entre la deuxième face (11) du module électronique et la deuxième face de contact thermique (5) du deuxième dispositif de refroidissement (3).

7. Ensemble électronique (1) selon l'une des revendications précédentes, dans lequel l'ensemble électronique (1) comporte un support de positionnement (25) arrangé recevoir le ou les module électronique de puissance (7) et pour permettre le positionnement relatif du module électronique de puissance (7), du premier dispositif de refroidissement (2) et du deuxième dispositif de refroidissement (3) lors de l'assemblage de l'ensemble électronique (1).

8. Ensemble électronique (1) selon l'une des revendications précédentes, comportant une pluralité de bagues d'ajustement (56) comportant :
- une face inférieure placée au contact d'une surface plane du support de positionnement (25) et/ou du premier dispositif de refroidissement (2) (2),
- une face supérieure parallèle à la structure de maintien (6), et placée en regard d'une zone élastique de la structure de maintien (6) de sorte que :
∘ lorsque la structure de maintien (6) est placée sans déformation au contact du deuxième dispositif de refroidissement (3), la face supérieure des bagues d'ajustement (56) est placée à une distance D de la structure de maintien (6),
∘ lorsque la structure de maintien (6) est déformée par la force exercée par les éléments de fixation (30), les parties élastiques de la structure de maintien (6) sont au contact de la face supérieure (45) des bagues d'ajustement (56).

9. Ensemble électronique (1) selon la revendication 8, dans lequel l'ajustement de la hauteur des bagues d'ajustement (56) permet d'ajuster les efforts verticaux générés sur la face d'appui du deuxième dispositif de refroidissement (3) par la structure de maintien (6).

10. Onduleur comportant un ensemble électronique (1) selon l'une des revendications précédentes.
